Europäisches Patentamt

European Patent Office

Office européen des brevets

Publication number: **0 286 031**
**A2**

# EUROPEAN PATENT APPLICATION

Application number: 88105309.4

Date of filing: 31.03.88

Int. Cl.⁴: **B23K 20/24 , B23K 20/10 , H01R 43/02**

Priority: 03.04.87 JP 81213/87

Date of publication of application:
**12.10.88 Bulletin 88/41**

Designated Contracting States:
**DE FR GB**

Applicant: **HITACHI, LTD.**
**6, Kanda Surugadai 4-chome Chiyoda-ku**
**Tokyo 100(JP)**

Applicant: **HITACHI COMPUTER PERIPHERALS**
**CO., LTD.**
**2880, Kouzu Odawara-shi**
**Kanagawa(JP)**

Inventor: **Hori, Kazunori**
**3-7, Nishisakawa 1-chome Odawara-shi**
**Kanagawa 256(JP)**
Inventor: **Taguchi, Minoru**
**23-4, Oogicho 5-chome Odawara-shi**
**Kanagawa 250(JP)**
Inventor: **Hara, Shigeo**
**696-3, Iizawa Minamiashigara-shi**
**Kanagawa 250-01(JP)**
Inventor: **Seto, Tokiyuki**
**320-16, Naruda Odawara-shi**
**Kanagawa 250(JP)**

Representative: **Altenburg, Udo, Dipl.-Phys. et**
**al**
**Patent- und Rechtsanwälte**
**Bardehle-Pagenberg-Dost-Altenburg**
**Frohwitter-Geissler & Partner Galileiplatz 1**
**Postfach 86 06 20**
**D-8000 München 86(DE)**

## Ultrasonic wire bonding method.

The ultrasonic wire bonding method for bonding the conductor of a sheathed wire to the terminal of an electronic part comprises the steps of forming a first rough-finished surface on either a portion of the sheath of the sheathed wire or the end of a bonding tip which is to be in contact with the sheath and to impart an ultrasonic vibration to sheath, while forming a second rough-finished surface on either another portion of the sheath of the sheathed wire or the face of the terminal of the electronic part to which the conductor of the sheathed wire is to be bonded: and placing the sheathed wire between the bonding tip and the terminal and imparting an ultrasonic vibration to the sheathed wire while lightly forcing the bonding tip to the terminal. The sheathed wire has the sheath thereof scraped without slipping and thus the conductor thereof naked, and this conductor is thereafter or simultaneously bonded to the terminal positively, which can improve the efficiency of wire bonding.

# FIG. 1

## Ultrasonic Wire Bonding Method

BACKGROUND OF THE INVENTION

a) Field of the Invention:

The present invention relates to an ultrasonic wire bonding method by which the conductor of a sheathed wire is bonded to a terminal by means of an ultrasonic bonding apparatus, and more particularly to a suitable ultrasonic wire-bonding method for bonding to a terminal a sheathed wire of which the conductor of a diameter in the order of microns is insulatively sheathed with a resin such as polyurethane, etc.

b) Description of the Prior Art:

For bonding the conductor of a sheathed wire to a terminal, various bonding methods including the ultrasonic bonding method, thermocompression-bonding method, combined ultrasonic/thermocompression method, etc. have been proposed and used in practice. Among them, the ultrasonic bonding method is widely used in the process of manufacturing various electronic parts for the reasons that it needs no heating, thus having little thermal influence on such electronic parts, it needs only a small compressive force and that it permits to provide a bonding between metals of different kinds and for other reasons. In this ultrasonic bonding method, first the conductor of a sheathed wire is placed in contact with a terminal to which the conductor is to be bonded, and the conductor and terminal are applied with a vibration while the end of the bonding tip of an ultrasonic bonding apparatus is forced to the conductor, thereby bonding the conductor to the terminal. In this method, it is necessary that the portion of the conductor to be bonded should be naked beforehand. Namely, as the preliminary step of the wire bonding process, the to-be-bonded portion of the conductor should be exposed by removing a part of the wire sheath that corresponds to the conductor portion.

In the thermocompression wire bonding method, the bonder of a thermocompression bonding apparatus is used to directly heat and melt the sheathed portion of a sheathed wire in order to remove the sheath, and thereafter the conductor portion thus naked is bonded to a terminal. Since the sheath is removed by heating, this method is not suitable for use in wire bonding of any electronic part likely to be thermally influenced. In addition, the sheath of a sheathed wire is melted more than necessary, resulting in an excessively long naked portion of the conductor, so that the naked or exposed conductor portion may possibly get in contact with any other adjoining conductive portion, causing a short-circuit. So this thermocompression bonding method is not suitable usable in case a plurality of sheathed wires of which the conductor diameter is on the order of microns is disposed adjacent to each other.

Furthermore, a wire bonding method using the aforementioned two methods in combination is disclosed in, for example, the Japanese Examined Patent Publication No. 57-59680, in which an ultrasonic horn is held as abutting a thermocompression bonding tip so that the latter will serve as an ultrasonic welding tip. So this method is not advantageous in that the apparatus carrying out the method is complicated.

SUMMARY OF THE INVENTION

The present invention has an object to provide a high-efficiency ultrasonic wire bonding method by which removal of insulative sheath and bonding can be done nearly simultaneously.

The present invention has another object to provide an ultrasonic wire bonding method by which the conductor of a sheathed wire can be positively and efficiently bonded to a terminal and the sheath of the sheathed wire has not to be removed by any other apparatus at the preliminary step of the bonding process.

The aforementioned object can be accomplished by providing an ultrasonic wire bonding method, comprising, according to the present invention, a step of forming a rough-finished surface on either the end of the bonding tip or the sheath of a sheathed wire while forming a rough-finished surface on either the sheath of the sheathed wire or a terminal to which the conductor of the sheathed wire is to be bonded, and a step of placing the sheathed wire between the bonding tip and the terminal and imparting an ultrasonic vibration to the sheathed wire while lightly forcing the bonding tip to the terminal, so that since the sheathed wire is given the ultrasonic vibration while being sandwiched between the rough-finished surfaces of the bonding tip and terminal, the conductor of the wire is naked with a part of the sheath thus removed and thereafter or simultaneously bonded to the terminal.

These and other objects and advantages of the present invention will be better understood from the ensuing description made, by way of example, of the embodiment of the present invention with reference to the drawings.


BRIEF DESCRIPTION OF THE DRAWINGS

Fig. 1 is a schematic perspective view of the core slider of a magnetic disk unit to which the wire bonding method according to the present invention is applied;

Fig. 2 is a schematic view showing the sheathed wire and the terminal of core slider as positioned;

Fig. 3 is a schematic view showing the sheathed wire positioned between between the bonding tip and terminal for the purpose of bonding;

Fig. 4 schematically shows the completed bonding between the sheathed wire and terminal; and

Fig. 5 is an explanatory drawing showing the relation of the time for connection or bonding and relative peeling strength with the surface roughness of the rough-finished surfaces.


DETAILED DESCRIPTION OF THE PREFERRED EMBODIMENT

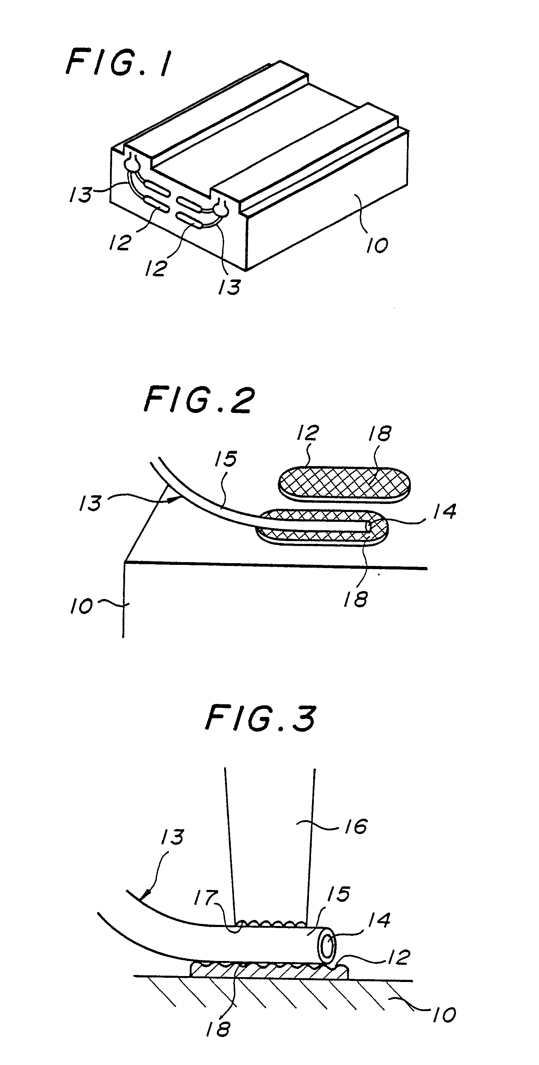

Referring now to Fig. 1, a core slider 10 of a magnetic disk unit to which the ultrasonic wire bonding method according to the present invention is applied is shown. To the terminal 12 of the core slider 10 is to be bonded a lead wire 13 as sheathed wire by means of an ultrasonic bonding apparatus (not shown). The lead wire 13 as sheathed wire consists of, for example, a conductor 14 made of a copper wire of which the diameter is on the order of 40 microns, and a sheath layer 15 of urethane resin surrounding the conductor 14 and of which the thickness is about 5 microns. In some sheathed wires, an Au layer of about several microns in thickness is provided between the conductor 14 and urethane-resin sheath layer 15.

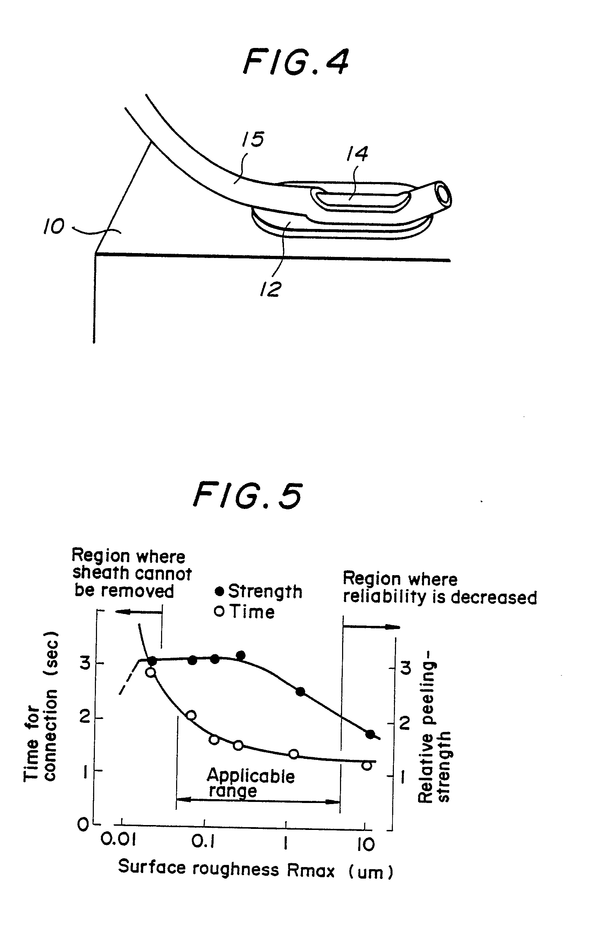

The ultrasonic bonding method according to the present invention is effected by sandwiching the lead wire 13 between the core-slider terminal 12 and a bonding tip 16 of the ultrasonic bonding apparatus, and imparting an ultrasonic vibration to the lead wire 13 while forcing the bonding tip 16 to the sheath 15 of the lead wire 13 with the lead wire retained as sandwiched as mentioned above. More specifically, first the end of the bonding tip of the well-known ultrasonic bonding apparatus is rough-finished, using a lapping tape or the like as shown in Fig. 3, to be finely knurled as indicated at the reference numeral 17. Also the surface of the terminal is similarly rough-finished, using the lapping tape or the like, to be finely knurled as indicated at the reference numeral 18. These rough-finished surfaces 17 and 18 are finished to such a roughness that when the end of the bonding tip 16 is lightly forced to the sheath 15 on the lead wire 13, their respective convex portions bite the sheath 15, increasing the frictional resistance between the surfaces and the sheath 15 for no slipping to occur between the sheath and surfaces. Thereafter, the entire core slider 10 is moved onto the bonding bench (not shown) of the ultrasonic bonding apparatus, the bottom face of the sheath 15 of the lead wire 13 to be bonded is placed so as to get into contact with the rough-finished surface 18 of the terminal 12 (as in Fig. 2), and an ultrasonic vibration is applied to the lead wire 13 for a few seconds while lightly forcing the bonding tip 16 of the ultrasonic bonding apparatus with a weight of about 170 g with the rough-finished surface 17 of the end of the bonding tip 16 being in contact with the top face of the sheath 15 on the lead wire 13. Thus, the ultrasonic vibration is applied from the bonding tip 16 while the convex portions of the rough-finished surfaces 17 and 18 are biting the top and bottom faces of the sheath 15 of the lead wire 13, the top and bottom faces of the sheath 15 are scraped so that the conductor 14 is exposed and positively bonded to the terminal 12. In this embodiment, the the bonding tip 16 has the end thereof formed 0.3 mm $\times$ 0.2 mm (rectangular) in size and circumferentially rounded. so that the portions longitudinally opposing to each other of the sheath 15 of the lead wire 13 are scraped roundly as shown in Fig. 4. Also in this embodiment, the rough-finished surfaces are formed on the end of the bonding tip 16 and on the surface of the terminal 12 to prevent any slipping between them. However, the present invention is not limited to this aspect, but in case the material of the sheath of the lead wire 13 is relatively rigid not like the urethane resin which is relatively soft, the top and bottom faces of the sheath 15 of the lead wire 13 may be rough-finished so that the frictional resistance between the sheath 15 of the lead wire 13 and the bonding tip 16 as well as the terminal 12 is greater. Therefore, the rough surface can be formed on either the end of the bonding tip 15 or the top face of the sheath 15 of the lead wire 13, and cn either the bottom face of the sheath 15 of the lead wire 13 or the surface of the terminal 12 to prevent any slipping between the bonding tip 16 and the sheath 15 as well as between the sheath 15 and the terminal 12.

The relation of the time for connection or bonding and the relative peeling strength with the roughness Rmax of the rough-finished surfaces 17 and 18, respectively, of the end of the bonding tip 16 and the terminal 12 is shown in Fig. 5. If the surfaces are excessively fine, slipping will take place between the bonding tip and sheath as well as the sheath and terminal, so that no positive bonding can be done. And if the surfaces are too rough, the sheath 15 will remain in the concave portions of the rough-finished surface 17 or 18, so that no positive bonding can be secured. In any of these cases, poor bonding will result. When the surface roughness is within a range from 0.05 to 5 microns, the above-mentioned problem will not take place and wire bonding can be satisfactorily effected.

As having been described in the foregoing, in the ultrasonic wire bonding method according to the present invention, since the ultrasonic vibration is applied to the sheathed wire while the wire is lightly forced by the bonding tip as retained with a large frictional resistance between the bonding tip and the terminal, the sheathed wire can have the sheath thereof scraped without slipping, the conductor thus naked, and thereafter or simultaneously the conductor is bonded to the terminal positively. Thus, the efficiency of the wire bonding can be improved. Furthermore, it is not necessary to remove the sheath by any other apparatus, but the sheath can be removed by means of a conventional ultrasonic bonding apparatus without the necessity of using any other apparatus in combination. Therefore, the construction of an apparatus intended for carrying out the method according to the present invention can be considerably simplified as compared with the conventional technique.

## Claims

1. An ultrasonic wire bonding method intended for bonding a conductor of a sheathed wire to a terminal of an electronic part, comprising the following steps of:

forming a first rough-finished surface on either a portion of the sheath of said sheathed wire or the end of a bonding tip which is to be in contact with said sheath and to impart an ultrasonic vibration to said sheath, while forming a second rough-finished surface on either another portion of the sheath of said sheathed wire or the face of the terminal of said electronic part to which the conductor of the sheathed wire is to be bonded; and

placing said sheathed wire between said bonding tip and said terminal and imparting an ultrasonic vibration to the sheathed wire while lightly forcing the bonding tip to the terminal.

2. An ultrasonic wire bonding method according to Claim 1, in which said first rough-finished surface is formed on the end of said bonding tip while said second rough-finished surface is formed on the face of said terminal.

3. An ultrasonic wire bonding method according to Claim 2, in which the roughness of said rough-finished surfaces is within a range from 0.05 to 5.0 microns.

# FIG. 1

# FIG. 2

# FIG. 3

# FIG.4

# FIG.5

Region where sheath cannot be removed

Region where reliability is decreased

● Strength
○ Time

Time for connection (sec)

Relative peeling-strength

Applicable range

Surface roughness Rmax (um)